# EUROPEAN PATENT APPLICATION

(11) **EP 3 444 163 A1**
(43) Date of publication of application: **20.02.2019**
(21) Application number: 18731950.4
(22) Date of filing: 25.05.2018
(51) Int. Cl.: B62B 1/14

(54) **TARGET CARRIER**

(30) Priority: 26.05.2017 CN 201720599880 U
(71) Applicant: Miasolé Equipment Integration (Fujian) Co., Ltd., 362005 Quanzhou Fujian (CN)
(72) Inventor: CHEN, Guanghua, Quanzhou Fujian 362005 (CN); ZENG, Yulin, Quanzhou Fujian 362005 (CN); HUANG, Xinan, Quanzhou Fujian 362005 (CN); WU, Fuzhong, Quanzhou Fujian 362005 (CN); CAI, Ailing, Quanzhou Fujian 362005 (CN)
(74) Representative: D'Halleweyn, Nele Veerle Trees Gertrudis
(86) International application number: PCT/CN2018/088484
(87) International publication number: WO 2018/214970

(57) **Abstract**

A target conveying vehicle includes a lifting vehicle and a target fixing device. The lifting vehicle includes a vehicle body (1) and load bars (2) which are arranged on the vehicle body (1) and able to be elevated and lowered. The target fixing device is arranged on the load bars (2), and includes a target carrier mechanism and at least one locking mechanism arranged on the target carrier mechanism. The at least one locking mechanism is arranged for fixing the target on the target carrier mechanism.

## Description

This application is based on and claims the priority of the Chinese patent application No. 201720599880.8 filed on May 26, 2017, the entire contents of which are hereby incorporated by reference.

### Technical Field

Embodiments of the present application relate to, but are not limited to, a conveying device, in particular to, but are not limited to, a target conveying vehicle.

### Background

A target is an important part in magnetron sputtering coating technology, in which the target is a target material bombarded by high-speed charged particles, and different film systems can be obtained by replacing different targets.

In the target production process, the target is mounted on the spraying platform and lathe for processing. When mounting and removing the target, it is usually done manually. However, as the target weighs up to 50 KG, the manual mounting and removing of the target will be time-consuming and laborious, and at least two workers may be required to complete this work, which severely wastes human resources. In addition, if the manual mounting and removing are not properly conducted, the surface of the target may be bumped, causing the target to be damaged and wasted.

### Summary

The following is an overview of the subject matter described in detail herein. This summary is not intended to limit the protection scope of the claims.

The application provides a target conveying vehicle which is used for mounting, removing and transferring targets and has the advantages of simple structure, easy to operate and high working efficiency.

The application adopts the following technical schemes.

A target conveying vehicle includes a lifting vehicle and a target fixing device. The lifting vehicle includes a vehicle body and load bars which are arranged on the vehicle body and able to be elevated and lowered. The target fixing device is arranged on the load bars. The target fixing device includes a target carrier mechanism and at least one locking mechanism arranged on the target carrier mechanism, and the at least one locking mechanism is arranged for fixing the target on the target carrier mechanism.

According to an embodiment of the application, load bars which are able to be elevated and lowered are arranged on the vehicle body, and a target fixing device is arranged on the load bars. Elevating and lowering of the load bars can drive the target fixing device to move up and down synchronously so as to move the target fixing device to a height suitable for mounting or removing the target. The target fixing device is used for fixing the target, and includes a target carrier mechanism and a locking mechanism. The target is placed on the target carrier mechanism, and the locking mechanism fixes the target on the target carrier mechanism. After the target is fixed on the target fixing device, the transfer function of the vehicle body can be utilized to realize the transfer of the target.

Therefore, the target transfer vehicle has the function of facilitating the transfer, installation and removal of the target, can replace manual operation, and has the advantages of simple structure, easy to operate and high working efficiency.

According to some embodiments of the present application, the target carrier mechanism includes a mounting bracket, a support plate and a carrier. The support plate is fixedly mounted on the load bars by means of the mounting bracket, and the carrier is fixedly mounted on the support plate and extends in a direction away from the mounting bracket.

According to some embodiments of the present application, at least two carriers are provided, and the mounting bracket and the carriers are fixedly arranged on opposite sides of the support plate respectively.

According to some embodiments of the present application, one carrier is provided, and the mounting bracket and the carrier are fixedly arranged on opposite sides of the support plate respectively.

According to some embodiments of the present application, the target carrier mechanism includes a mounting bracket, a support plate and a carrier. The support plate is fixedly mounted on the load bars by means of the mounting bracket, and the carrier is movably mounted on the support plate and extends in a direction away from the mounting bracket.

According to some embodiments of the present application, the carrier is provided with a positioning groove, and the positioning groove has an upward opening.

According to some embodiments of the present application, the mounting bracket includes a first plate which is arranged along the horizontal direction and fixedly connected to the load bars and a second plate which is vertically fixed to the first plate and on which the support plate is mounted.

According to some embodiments of the present application, reinforcing ribs are provided between the second plate and the first plate.

According to some embodiments of the present application, the target conveying vehicle further includes a horizontal position adjusting mechanism which includes sliders mounted on one of the support plate and the mounting bracket and a slide rail mounted on the other of the support plate and the mounting bracket. The slide rail is slidingly connected with the two sliders.

According to some embodiments of the present application, the target conveying vehicle further includes a horizontal position adjusting mechanism which includes sliders and a slide rail. The slide rail is fixedly mounted on the side of the support plate close to the second plate. Two sliders are provided, and the sliders are symmetrically mounted on the second plate.

According to some embodiments of the present application, the target conveying vehicle further includes a horizontal position adjusting mechanism which includes a slider mounted on one of the load bar and the vehicle body and a slide rail mounted on the other of the load bar and the vehicle body. The slide rail is slidingly connected with the slider.

According to some embodiments of the present application, the target conveying vehicle further includes a horizontal position adjusting mechanism which includes a slider mounted on one of the load bar and the target fixing device and a slide rail mounted on the other of the load bar and the target fixing device. The slide rail is slidingly connected with the slider.

According to some embodiments of the present application, the horizontal position adjusting mechanism further includes a protective cover which is sleeved on at least part of the slide rail.

According to some embodiments of the present application, the protective cover is telescopically connected between the slider and the end of the slide rail.

According to some embodiments of the present application, two protective covers are provided, and wherein ends of the two protective covers are fixedly connected to the sliders, and the other ends of the two protective covers are respectively fixedly connected to the two ends of the slide rail.

According to some embodiments of the present application, the target conveying vehicle further includes a position fixing mechanism which includes a position fixing pin and position fixing holes mated with the position fixing pin. The position fixing holes are respectively arranged in the support plate and the mounting bracket, and the position fixing pin is able to insert into and fix to the position fixing holes or separated from the position fixing holes.

According to some embodiments of the present application, the target conveying vehicle further includes a position fixing mechanism which includes a position fixing plate and a position fixing pin. The second plate is provided with a mounting hole into which the position fixing pin is inserted. The position fixing plate is fixed to the support plate. The position fixing plate is provided with a position fixing hole, and the position fixing pin is able to insert into and fix to the position fixing hole or separated from the position fixing hole.

According to some embodiments of the present application, the target conveying vehicle further includes a position fixing mechanism which includes a position fixing pin and position fixing holes mated with the position fixing pin. The position fixing holes are respectively arranged in the load bar and the vehicle body, and the position fixing pin is able to insert into and fix to the position fixing holes or separated from the position fixing holes.

According to some embodiments of the present application, the target conveying vehicle further includes a position fixing mechanism which includes a position fixing pin and position fixing holes mated with the position fixing pin. The position fixing holes are respectively arranged in the load bar and the target fixing device, and the position fixing pin is able to insert into and fix to the position fixing holes or separated from the position fixing holes. Other aspects will become apparent after reading and understanding the brief description of the drawings and the embodiments of this application.

### Brief Description of Drawings

From the following detailed description when considered in conjunction with the accompanying drawings, a more complete and better understanding of the embodiments of the present application and many advantages thereof will be readily obtained. The drawings illustrated herein are provided to provide a further understanding of the embodiments of the present application and constitute a part of the embodiments of this application. The exemplary embodiments of the present application and the description thereof are used to explain the present application and do not constitute a limitation on the present application. In the drawings:
Fig. 1 is a schematic view of the overall structure of a target conveying vehicle according to an embodiment of the present application;
Fig. 2 is an exploded schematic view of part of the structure of a target conveying vehicle according to an embodiment of the present application;
Fig. 3 is a schematic view of a locking mechanism of a target conveying vehicle according to an embodiment of the present application.

Description of reference signs: 1 - vehicle body, 2 - load bar, 3 - target carrier mechanism, 4 - locking mechanism, 5 - mounting bracket, 6 - support plate, 7 - carrier, 8 - positioning groove, 9 - slider, 10 - protective cover, 11 - position fixing plate, 12 - position fixing pin, 13 - first plate, 14 - second plate, 15 - reinforcing rib, 16 - pad plate, 17 - clamping arm, 18 - handle, 19 - base, 20 - pressing head, 21 - receiving groove, 22 - horizontal portion, 23 - vertical portion, 24 - bolt, 25 - through hole, 26 - adjusting nut.

### Detailed Description

Embodiments of the present application are described in detail below, and examples of the embodiments are shown in the accompanying drawings, in which the same or similar numerals denote the same or similar elements or elements having the same or similar functions throughout. The embodiments described below with reference to the accompanying drawings are exemplary, and are only used to explain the present application but cannot be construed as limiting the present application.

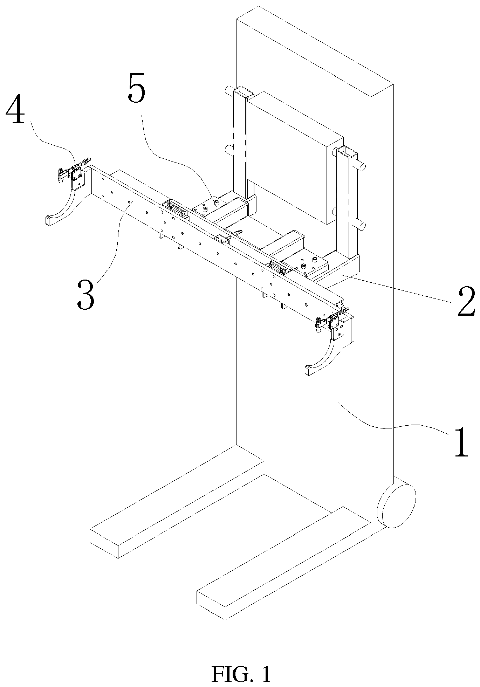

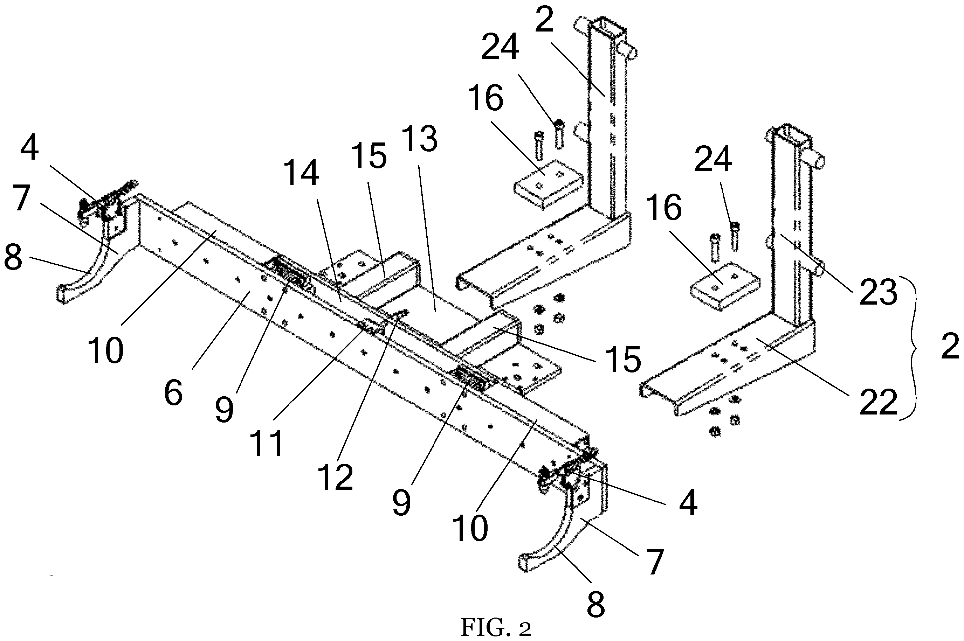

As shown in Figs. 1-3, a target conveying vehicle including a lifting vehicle according to some embodiments of the present application is exemplarily shown. The lifting vehicle includes a vehicle body 1 and load bars 2 which are arranged on the vehicle body 1 and able to be elevated and lowered. Load bars 2 can be elevated and lowered relative to the vehicle body 1 in an up and down direction.

The load bars 2 are provided with a target fixing device which is used for fixing the target. When the load bars 2 are elevating or lowering, they can drive the target fixing device to move up and down synchronously, so as to move the target fixing device to a height suitable for mounting or removing the target, facilitating fixing the target on the target fixing device. After the target is fixed on the target fixing device, the transfer function of the vehicle body 1 can be utilized to realize the transfer of the target.

Therefore, the target transfer vehicle has the function of facilitating the transfer, installation and removal of the target, and can be used as an alternative to the manual operation of the target. The target transfer vehicle has the advantages of simple structure, convenience in operation and high working efficiency.

In an embodiment shown in the drawings, the load bar 2 has an L shape. The vertical portion 23 of the L shape is used to connect with the vehicle body 1, and the horizontal portion 22 of the L shape is used to connect with the target fixing device so as to support the target fixing device. In order to improve the support capacity of the load bars, there may be provided a plurality of the load bars 2. In the embodiment shown in the drawings, there are two load bars 2 on which the target fixing device is installed, and two load bars 2 move synchronously.

The target fixing device includes a target carrier mechanism 3 and a locking mechanism 4. The target carrier mechanism 3 is used for carrying the target and at least one locking mechanism 4 is arranged on the target carrier mechanism 3. The locking mechanism 4 is used for fixing the target on the target carrier mechanism 3.

When in use, the target is placed on the target carrier mechanism 3, and then the target is fixed on the target carrier mechanism 3 by means of the locking mechanism 4. The transfer and height adjustment of the target are realized by operating the vehicle body 1, so as to realize the transfer and installation of the target.

For example, when removing the target from a certain station (such as spraying platform, etc.), firstly the height of the load bars 2 on the vehicle body 1 is adjusted to make the target carrier mechanism 3 contact with the target, then the target is fixed on the target carrier mechanism 3 by means of the locking mechanism 4, after that the target is removed from the lathe or spraying platform, and finally the target is transferred to other stations (such as lathe, etc.) by the vehicle body 1. When the target is detached from the target transfer vehicle and installed on a certain station, firstly, the height of the load bars 2 on the vehicle body 1 is adjusted so that the target on the target carrier mechanism 3 contacts with the installation platform on the station, and then the locking mechanism 4 is released so that the target is supported on the installation platform, and after that the target transfer vehicle is moved away.

The above target carrier mechanism 3 includes a mounting bracket 5, a support plate 6 and carriers 7. The support plate 6 is mounted on the load bars 2 by means of the mounting bracket 5, and the carriers 7 are mounted on the support plate 6 and used for supporting the target.

In the embodiment shown in the drawings, the mounting bracket 5 and the carriers 7 are respectively arranged on opposite sides of the support plate 6. The carriers 7 extend in a direction away from the mounting bracket 5. In the drawings, the mounting bracket 5 is located on the side of the support plate 6 close to the load bars 2, and the carriers 7 extend in a direction away from the load bars 2. The mounting bracket 5 is fixedly mounted on the load bars 2, and the height adjustment of the support plate 6 and the carriers 7 is realized by adjusting the height adjustment of the load bars 2.

The carriers 7 are used to carry the target, thus there are at least two carriers. In the embodiment shown in the drawings, two carriers 7 are used, and the two carriers 7 are respectively arranged at two ends of the support plate 6. From a safety point of view, in order to prevent an accident from occurring when one of the carriers 7 is damaged, the number of the carriers 7 can also be set to 3 or 4 or more. It will be understood by those skilled in the art that the carriers 7 should be arranged at the same height so that the target can be positioned in a horizontal position.

Of course, the number of the carrier 7 can also be one, and the target can be supported by one carrier 7. In order to enable the carrier 7 to stably support the target, the width of the carrier 7 can be set relatively large, which can increase the support area between the carrier 7 and the target and thus improve the support stability.

In some embodiments of the present application, the target carrier mechanism 3 includes a mounting bracket 5, a support plate 6 and a carrier 7. The support plate 6 is fixedly mounted on the load bars 2 by means of the mounting bracket 5. The mounting bracket 5 and the carrier 7 are respectively arranged on opposite sides of the support plate 6. The carrier 7 is movably mounted on the support plate 6 and extends in a direction away from the mounting bracket.

In an exemplary embodiment, there are provided at least two carriers 7 which are movably mounted on the support plate 6. The distance between the carriers 7 is adjusted by moving the carriers 7, thereby the carriers 7 are suitable for supporting targets of different lengths. In another exemplary embodiment, there is provided one carrier 7 which is movably mounted on the support plate 6. The position of the carrier 7 is adjusted by moving the carrier 7, thereby the carrier 7 is suitable for supporting targets. In another exemplary embodiment, there is provided one or at least two carriers 7 which are rotatably mounted on the support plate 6. The position of the carrier(s) 7 is adjusted by rotating the carrier(s) 7 thereby the carrier(s) 7 is suitable for supporting targets. In order to fix the target, in some exemplary embodiments, a positioning groove 8 with an upward opening can be provided on the carrier 7, and the target can be mounted in the positioning groove 8 so as to position and fix the target. As the target is generally a cylindrical shape structure, in the embodiment shown in the drawings, the positioning groove 8 on the carrier 7 is an arc-shaped positioning groove with an upward opening, which can put the target in position. The radian of the arc-shaped positioning groove can be designed according to the outer diameter of the target. It should be understood that the positioning groove 8 can also be provided in other shapes, such as rectangle and the like.

In other exemplary embodiments, the carrier 7 is provided with a supporting plane instead of a positioning groove. The target is supported on the supporting plane, and then the target is tightly fixed on the supporting plane by the locking mechanism 4.

With respect to the structural strength of the present application, a mounting bracket with relatively high strength is provided since the mass of the target is relatively large and usually not less than 50 KG. The mounting bracket 5 includes a first plate 13 and a second plate 14. The first plate 13 is horizontally arranged and fixedly connected with the load bar 2 through bolts 24. The second plate 14 is vertically fixed to the first plate 13. Preferably, the first plate 13 and the second plate 14 are formed into a one-piece structure, and adopt an L-shape design as a whole, such as an L-shape mounting bracket formed by bending. Alternatively, the first plate 13 and the second plate 14 can be fixed by other ways, such as welding, bonding and the like.

Reinforcing ribs 15 are arranged between the second plate 14 and the first plate 13. The strength of the mounting bracket can be effectively improved by the arrangement of the reinforcing ribs 15. In order to improve the stability of the mounting bracket, there may be provided a plurality of reinforcing ribs 15. In the embodiment shown in the drawings, there are provided two reinforcing ribs 15, and the distance between the two reinforcing ribs 15 is slightly less than the distance between the two load bars 2. The bolts 24 fix the portions of the first plate 13 located outside the two reinforcing ribs 15 to the horizontal portions 22 of the load bars 2.

While fixing the first connecting plate 13, two pad plates 16 are arranged above the first plate, and the pad plates 16 are pressed against the upper surface of the first connecting plate 13 by bolts. One lateral surface of each pad plate 16 abuts against a lateral surface of the adjacent reinforcing rib 15, which can effectively fix the position of the first connecting plate 13 and improve the stability thereof. In an example shown in the drawings, the pad plate 16 is a rectangular plate. The pad plate 16 may be an aluminum plate, or a metal or non-metal plate made of other materials.

In some embodiments, the target conveying vehicle may further include a horizontal position adjustment mechanism for adjusting the horizontal position of the carriers 7 so as to facilitate the removal and installation of the target. For example, when removing the target from a certain station (such as a spraying platform, etc.), it is necessary for the carriers 7 to contact with the target. However due to various factors such as the available space, the vehicle body 1 may not be able to move to a position where the carriers 7 can contact with the target. At this point the carriers 7 can be moved horizontally so that the carriers 7 can be brought into contact with the target. When removing the target from the target transfer vehicle and mounting the same on a station, it is necessary to make the target on the carriers 7 contact with the installation platform on the station. However due to various factors such as the available space, the vehicle body 1 may not be able to move to a position where the target on the carriers 7 can contact with the installation platform on the station. At this point the carriers 7 can be moved horizontally so that the target can be brought into contact with the installation platform on the station.

The horizontal position adjusting mechanism can adjust the horizontal position of the carriers 7 by adjusting the horizontal position of the load bars 2. Alternatively, the horizontal position adjusting mechanism can adjust the horizontal position of the carriers 7 by adjusting the horizontal position of the target fixing device relative to the load bars 2. Alternatively, the horizontal position adjusting mechanism can adjust the horizontal position of the carriers 7 by adjusting the horizontal position of the support plate 6 relative to the mounting bracket 5.

In the embodiment shown in the drawings, the horizontal position adjusting mechanism can adjust the horizontal position of the carriers 7 and hence the horizontal position of the target by adjusting the horizontal position of the support plate 6 relative to the mounting bracket 5. The horizontal position adjusting mechanism includes sliders 9 and a slide rail. The slide rail is fixedly arranged on the plate surface of the support plate 6 close to the second plate 14. There are two sliders 9 which are symmetrically arranged on the second plate 14. The slide rail is slidingly connected with the two sliders 9. By the arrangement of the horizontal position adjusting mechanism, the horizontal position of the support plate 6 and the carriers 7 fixed on the support plate 7 and hence the horizontal position of the target fixed on the carriers 7 can be adjusted, facilitating the installation and removal of the target.

It should be understood that it is also possible to fixedly mount the slide rail arrangement on the second plate 14 and fixedly mount the two sliders 9 on the support plate 6. The number of the sliders 9 can be one or more than three (including three). In other embodiments, the horizontal position adjusting mechanism is used to adjust the horizontal position of the load bar 2 relative to the vehicle body 1, so as to achieve the purpose of adjusting the horizontal position of the carrier 7 and the target. In this way, the load bar 2 may not only move in an up and down direction with respect to the vehicle body 1, but also move horizontally with respect to the vehicle body 1. For example, the horizontal position adjustment mechanism includes a slider and a slide rail. The slider is installed on one of the load bar 2 and the vehicle body 1, and the slide rail is installed on the other of the load bar 2 and the vehicle body 1. The slide rail is slidingly connected with the slider. By the arrangement of the horizontal position adjusting mechanism, the load bar 2 is enabled to move horizontally, thus driving the target fixed on the target fixing device to move horizontally.

For example, the slider may be provided on the vertical portion 23 of the L-shape load bar 2 on the side facing the vehicle body, and the slide rail may be provided on the vehicle body 1. The slide rail is slidably connected with the slider.

In still other embodiments, the horizontal position adjusting mechanism adjusts the horizontal position of the carrier 7 and the target by adjusting the horizontal position of the target fixing device relative to the load bar 2. The horizontal position adjusting mechanism includes a slider and a slide rail. The sider is arranged on one of the load bar 2 and the target fixing device, and the slide rail is arranged on the other of the load bar 2 and the target fixing device. The slide rail is slidingly connected with the slider.

For example, the slider may be provided on the upper surface of the horizontal portion 22 of the L-shape load bar 2, and the slide rail may be provided on the lower surface of the first plate 13 of the mounting bracket. The slide rail is slidably connected with the slider.

It should be understood that the above discloses three horizontal position adjustment mechanisms: a horizontal position adjustment mechanism for adjusting the horizontal position of the load bar 2 relative to the vehicle body 1, a horizontal position adjustment mechanism for adjusting the horizontal position of the target fixing device relative to the load bar 2, and a horizontal position adjustment mechanism for adjusting the horizontal position of the support plate 6 relative to the mounting bracket 5. In the target conveying vehicle, it is possible to provide only one of these horizontal position adjusting mechanisms, or provide two or three horizontal position adjusting mechanisms so as to increase the range of horizontal displacement of the target. For example, in the case that the load bar 2 can be horizontally moved with respect to the vehicle body 1, the target fixing device can be fixed on the load bar 2 and cannot move with respect to the load bar 2. Alternatively, the target fixing device can move horizontally with respect to the load bar 2, so as to increase the range of horizontal displacement of the target fixing device.

In order to improve the sliding smoothness between the slide rail and the slider 9, grease may be coated on the slide rail. As grease has good viscosity, in order to prevent dust from gathering on the sliding rail, a protective cover 10 can be sleeved on the slide rail, and the protective cover 10 can cover at least part of the slide rail.

In the embodiment shown in the drawings, two ends of the slide rail are provided with protective covers 10 which are sleeved on the slide rail and telescopically connected between the sliders 9 and the ends of the slide rail. In other words, the protective cover 10 can be stretched or compressed. One end of the protective cover 10 is fixedly connected with the slider 9, and the other end thereof is fixedly connected with the end of the slide rail. In this way, when adjusting the horizontal position of the support plate 6, one of the protective covers 10 can be stretched and the other protective cover 10 can be compressed, so that the part of the slide rail between its end and the slider 9 is always protected by the protective cover 10. By the arrangement of the protective cover 10, the sliding rail can be kept clean and effectively protected from being damaged by collision.

The protective cover 10 may be made of rubber or other materials, such as silicone or the like.

The protective cover 10 can be a bellows-like protective cover so that it can be stretched or compressed along with the horizontal movement of the support plate 6. The protective cover 10 may also include a plurality of sub-protective covers which are slidably connected. The stretch and compression of the protective cover 10 can be realized by means of the sliding connection between the sub-protective covers, so that the protective cover 10 can be stretched or compressed along with the horizontal movement of the support plate 6.

In other embodiments, the protective cover can completely cover the slide rail. For example, one protective cover can be provided so that it is sleeved on the slide rail and the two ends of the protective cover are respectively fixed to the two ends of the slide rail so as to completely cover the slide rail.

As the target does not need to be horizontally adjusted in the process of transfer, from a safety point of view, a position fixing mechanism may be provided for fixing the position of the horizontally movable load bar 2 relative to the vehicle body 1, or fixing the position of the horizontally movable target fixing device relative to the load bar 2, or fixing the position of the horizontally movable support plate 6 relative to the mounting bracket 5.

In the embodiment shown in the drawings, the support plate 6 may be horizontally movable relative to the mounting bracket 5. The position fixing mechanism is used to fix the horizontal position of the support plate 6 relative to the mounting bracket 5 during the target transfer process, and release the support plate 6 from the mounting bracket 5 so that the support plate 6 can be horizontally moved relative to the mounting bracket 5 during the target removal process.

In the embodiment shown in the drawings, the position fixing mechanism can include a position fixing plate 11 and a position fixing pin 12. A mounting hole is provided in the middle of the second plate 14, and the position fixing pin 12 is inserted into the mounting hole. The position fixing plate 11 is fixed at the middle of the support plate 6, and the position fixing plate 11 is provided with a position fixing hole into which the position fixing pin 12 may fit.

When the adjustment of the horizontal position is not needed, the center line of the support plate 6 is aligned with the center line of the second plate 14 so that the position fixing hole on the position fixing plate 11 is coaxial with the mounting hole on the second plate 14, and then the position fixing pin 12 can be inserted into the position fixing hole so that the support plate 6 cannot move horizontally, effectively ensuring the safety of the transfer. When the adjustment of the horizontal position of the target is desired, the position fixing pin 12 is separated from the position fixing hole so that the support plate 6 can horizontally move relative to the second plate 14 to adjust the horizontal position of the target.

It will be understood that the position fixing plate 11 may not be provided, and the position fixing hole may be directly formed in the middle of the support plate 6. It will also be understood that the positions of the mounting hole and position fixing hole are not limited to the middle of the support plate 6 and the second plate 14. In contrast the mounting hole and position fixing hole may be provided in any other positions.

In other embodiments, the load bar 2 can move horizontally relative to the vehicle body 1, and the position fixing mechanism is used to fix the horizontal position of the load bar 2 during target transfer process. The position fixing mechanism may include a position fixing pin, and the load bar 2 and the vehicle body 1 are provided with position fixing holes. The position fixing pin is inserted into the two position fixing holes to horizontally fix the load bar 2 to the vehicle body 1. For example, a position fixing hole may be formed in the vertical portion 23 of the L-shape load bar 2 on the side facing the vehicle body, and another position fixing hole may be formed in the vehicle body 1. The position fixing pin can be inserted into and fit to the position fixing holes in the load bar 2 and the vehicle body 1 to fix the horizontal position of the load bar 2. The position fixing pin can also be separated from the position fixing holes in the load bar 2 and the vehicle body 1, so that the load bar 2 can move horizontally relative to the vehicle body 1.

In still other embodiments, the target fixing device can move horizontally relative to the load bar 2, and the position fixing mechanism is used to fix the horizontal position of the target fixing device during target transfer process. The position fixing mechanism may include a position fixing pin, and the load bar 2 and the target fixing device are provided with position fixing holes. The position fixing pin is inserted into the two position fixing holes to horizontally fix the load bar 2 to the target fixing device. For example, a position fixing hole may be formed in the horizontal portion 22 of the L-shape load bar 2, and a position fixing hole may be formed in the first plate 13 of the mounting bracket 5. The position fixing pin can be inserted into and fit to the position fixing holes in the load bar 2 and the first plate 13 to fix the horizontal position of the target fixing device. The position fixing pin can also be separated from the position fixing holes in the load bar 2 and the first plate 13, so that the target fixing device can move horizontally relative to the load bar 2.

The lifting vehicle and locking mechanism 4 will be described in detail below.

The lifting vehicle 1 at least has a vehicle body 1, load bars 2 and a load bar height adjustment mechanism. The load bar height adjustment mechanism can be either a manual adjustment mechanism or an automatic adjustment mechanism, that is, the lifting vehicle can be either a manual lifting vehicle or an automatic lifting vehicle. When a manual lifting vehicle is used, the load bar height adjustment mechanism usually includes a vertical load bar mounting bracket, and an adjusting handwheel and a sprocket-chain transmission assembly arranged on the load bar mounting bracket. The load bar mounting bracket is used for mounting load bars, and the sprocket-chain transmission assembly is arranged between the adjusting handwheel and the load bars. The height of the load bar on the load bar mounting bracket is adjusted by the adjusting handwheel and the sprocket-chain transmission assembly.

When an automatic lifting vehicle is used, the load bar height adjustment mechanism usually includes a vertical load bar mounting bracket, a sprocket-chain transmission assembly and a driving motor. The load bar mounting bracket is used for mounting load bars, and the sprocket-chain transmission assembly is arranged between the driving motor and the load bars. The height of the load bar on the load bar mounting bracket is adjusted by means of the driving motor and the sprocket-chain transmission assembly.

Universal wheels are usually arranged at the bottom of the vehicle body of the lifting vehicle, so that the position adjustment of the lifting vehicle can be achieved by manually pushing or dragging the load bar mounting bracket, so as to realize the transfer of the target. In addition, the automatic position adjustment of the vehicle body can be achieved by means of an automatic driving mechanism, so as to realize the automatic rotation of the target.

It will be understood that in addition to the lifting vehicle having the above structure, any lifting vehicle having the function of adjusting the height of the load bar can be applied to this application.

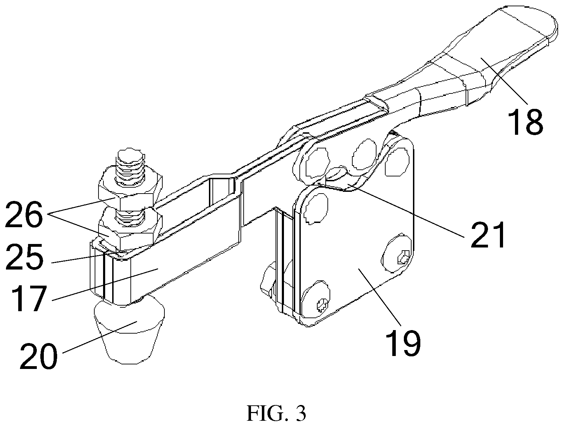

The locking mechanism 4 can adopt a welding clamp, which is available on the market. The embodiment shown in the drawings provides an exemplary clamp structure, as shown in Fig. 3, which is a simple manual clamp including a clamping arm 17, a handle 18, a base 19, a pressing head 20 and a connecting rod. The clamping arm 17 and the handle 18 each have two mounting portions. The pressing head 20 is mounted on one end of the clamping arm 17, and the other end of the clamping arm 17 is provided with two mounting portions. One of mounting portions of the clamping arm 17 is rotatably connected to the top of the base 19, and the other mounting portion is rotatably connected to one of the mounting portions on the handle 18. The other mounting portion on the handle 18 is rotatably connected to one end of the connecting rod, and the other end of the connecting rod is rotatably connected to the top of the base 19. The mounting positions of the clamping arm 17 and the connecting rod on the base 19 are at the same height, and there is a receiving groove 21 between the two mounting positions. By pressing the handle 18, the pressing head 20 of the clamp can be pressed against the target supported on the target carrier mechanism 2, or the target can be released.

The lower end of the pressing head 20 is of a rubber structure, and the upper end is a bolt. The end of the pressing arm 17 is provided with a through hole 25 through which the blot can pass. The bolt is provided with an adjusting nut 26. The overall height of the pressing head 20 can be adjusted by the adjusting nut 26, so as to adjust the extent to which the pressing head 20 presses against the target. In the embodiment shown in the drawings, there are two adjusting nuts 26 used for fastening.

It should be understood that in addition to the above-mentioned structure, the locking mechanism 4 can also adopt other manual or automatic clamps having the clamping function.

The structure, features, and effects of the present application have been described above in detail according to the embodiments shown in the drawings. The above described embodiments are only the preferred embodiments of the present application. The scope of the present application is not limited to the embodiments shown in the drawings. Changes made based on the conception of the present application, or equivalent modifications to embodiments are within the protection scope of the present application as long as they do not exceed the spirit covered by the description and the drawings.

## Claims

1. A target conveying vehicle comprising a lifting vehicle and a target fixing device, wherein the lifting vehicle comprises a vehicle body (1) and load bars (2) which are arranged on the vehicle body (1) and able to be elevated and lowered, and the target fixing device is arranged on the load bars (2), and
wherein the target fixing device comprises a target carrier mechanism (3) and at least one locking mechanism (4) arranged on the target carrier mechanism (3), and the at least one locking mechanism (4) is arranged for fixing a target on the target carrier mechanism (3).

2. The target conveying vehicle according to claim 1, wherein the target carrier mechanism (3) comprises a mounting bracket (5), a support plate (6) and a carrier (7), and wherein the support plate (6) is fixedly mounted on the load bars (2) by means of the mounting bracket (5), and the carrier (7) is fixedly mounted on the support plate (6) and extends in a direction away from the mounting bracket (5).

3. The target conveying vehicle according to claim 2, wherein at least two carriers (7) are provided, and the mounting bracket (5) and the carriers (7) are fixedly arranged on opposite sides of the support plate (6) respectively.

4. The target conveying vehicle according to claim 2, wherein one carrier (7) is provided, and the mounting bracket (5) and the carrier (7) are fixedly arranged on opposite sides of the support plate (6) respectively.

5. The target conveying vehicle according to claim 1, wherein the target carrier mechanism (3) comprises a mounting bracket (5), a support plate (6) and a carrier (7), and wherein the support plate (6) is fixedly mounted on the load bars (2) by means of the mounting bracket (5), and the carrier (7) is movably mounted on the support plate (6) and extends in a direction away from the mounting bracket (5).

6. The target conveying vehicle according to any one of claims 2-5, wherein the carrier (7) is provided with a positioning groove (8), and the positioning groove (8) has an upward opening.

7. The target conveying vehicle according to any one of claims 2-6, wherein the mounting bracket (5) comprises a first plate (13) which is arranged along a horizontal direction and fixedly connected to the load bars (2) and a second plate (14) which is vertically fixed to the first plate (13) and on which the support plate (6) is mounted.

8. The target conveying vehicle according to claim 7, wherein reinforcing ribs (15) are provided between the second plate (14) and the first plate (13).

9. The target conveying vehicle according to any one of claims 2-8, further comprising a horizontal position adjusting mechanism which comprises sliders (9) mounted on one of the support plate (6) and the mounting bracket (5) and a slide rail mounted on the other of the support plate (6) and the mounting bracket (5), wherein the slide rail is slidingly connected with the sliders (9).

10. The target conveying vehicle according to claim 7 or 8, further comprising a horizontal position adjusting mechanism which comprises sliders (9) and a slide rail, wherein the slide rail is fixedly mounted on the side of the support plate (6) close to the second plate (14), and wherein two sliders (9) are provided, and the sliders (9) are symmetrically mounted on the second plate (14).

11. The target conveying vehicle according to any one of claims 1-8, further comprising a horizontal position adjusting mechanism which comprises a slider mounted on one of the load bar (2) and the vehicle body (1) and a slide rail mounted on the other of the load bar (2) and the vehicle body (1), wherein the slide rail is slidingly connected with the slider.

12. The target conveying vehicle according to any one of claims 1-8, further comprising a horizontal position adjusting mechanism which comprises a slider mounted on one of the load bar (2) and the target fixing device and a slide rail mounted on the other of the load bar (2) and the target fixing device, wherein the slide rail is slidingly connected with the slider.

13. The target conveying vehicle according to any one of claims 9-12, wherein the horizontal position adjusting mechanism further comprises a protective cover (10) which is sleeved on at least part of the slide rail.

14. The target conveying vehicle according to claim 13, wherein the protective cover (10) is telescopically connected between the slider (9) and an end of the slide rail.

15. The target conveying vehicle according to claim 14, wherein two protective covers (10) are provided, and wherein one end of each of the two protective covers (10) is fixedly connected to the slider (9), and the other ends of the two protective covers (10) are respectively fixedly connected to two ends of the slide rail.

16. The target conveying vehicle according to any one of claims 9 and 13-15, further comprising a position fixing mechanism which comprises a position fixing pin and position fixing holes mated with the position fixing pin, wherein the position fixing holes are respectively arranged in the support plate (6) and the mounting bracket (5), and the position fixing pin is able to insert into and fix to the position fixing holes or separated from the position fixing holes.

17. The target conveying vehicle according to any one of claims 10 and 13-15, further comprising a position fixing mechanism which comprises a position fixing plate (11) and a position fixing pin (12), wherein the second plate (14) is provided with a mounting hole into which the position fixing pin (12) is inserted, and wherein the position fixing plate (11) is fixed to the support plate (6), and wherein the position fixing plate (11) is provided with a position fixing hole, and the position fixing pin is able to insert into and fix to the position fixing hole or separated from the position fixing hole.

18. The target conveying vehicle according to any one of claims 11 and 13-15, further comprising a position fixing mechanism which comprises a position fixing pin and position fixing holes mated with the position fixing pin, wherein the position fixing holes are respectively arranged in the load bar (2) and the vehicle body (1), and the position fixing pin (12) is able to insert into and fit to the position fixing holes or separated from the position fixing holes.

19. The target conveying vehicle according to any one of claims 12-15, further comprising a position fixing mechanism which comprises a position fixing pin and position fixing holes mated with the position fixing pin, wherein the position fixing holes are respectively arranged in the load bar (2) and the target fixing device, and the position fixing pin is able to insert into and fit to the position fixing holes or separated from the position fixing holes.
